Europäisches Patentamt

European Patent Office

Office européen des brevets

(11) Publication number: **0 084 300**
**A2**

(12) **EUROPEAN PATENT APPLICATION**

(21) Application number: 82850157.7

(22) Date of filing: 15.07.82

(51) Int. Cl.³: **D 06 Q 1/04**

(30) Priority: 19.01.82 SE 8200270

(43) Date of publication of application:
27.07.83 Bulletin 83/30

(84) Designated Contracting States:
CH DE GB IT LI NL SE

(71) Applicant: Bergström, Axel Emil
Vittsjöhus
Vittsjö(SE)

(71) Applicant: Södervall, Billy
Kungsgatan 19
Markaryd(SE)

(72) Inventor: Bergström, Axel Emil
Vittsjöhus
Vittsjö(SE)

(72) Inventor: Södervall, Billy
Kungsgatan 19
Markaryd(SE)

(74) Representative: Avellan-Hultmann, Bengt A.
HULTMANS PATENTBYRA AKTIEBOLAG Jungfrugatan
16
Stockholm 5(SE)

(54) A method for metal covering of textile materials.

(57) Textile materials are covered by metal by a preparatory treatment comprising ionization of the textile material and, thereafter, by a subsequent treatment in which a reduction means is present in a treatment bath, also comprising a sulphomalte of the metal or metals, respectively, by which the textile material shall be covered.

EP 0 084 300 A2

## A method for metal covering textile materials

From the Swedish patent specification 319.744 a method is known for co-
vering textile fibres or fabrics thereof with metal, whereby one, perhaps after washing away impurities or appreture means of the fibre,
adds to the fibre, so treated, a cover of a catalyzing metal and immer-
ges the fibre, provided with catalytic metal into a salt bath of the
metal or metals, respectively, which should be precipitated. The salt
bath comprises a reduction means. After the desired thickness of the
layer has been achieved from the precipitation metal, the fibre is removed from the bath. The fibre, however, is ionized before the layer
of catalyzing metal is brought on.

This method causes a metallization of the textile material, which
is perfect in many but not in all respects. As a matter of fact, the
method according to the said Swedish patent specification, when first
proposed, was in first place intended to create radar reflection, and
for the radar reflection, the electric conductivity only is of subordinated importance. However, it has proved that the method will also
be possible to use for other purposes, and amongst such other purposes of use may be mentioned covering of textile materials for use in
silk screen printing, using it for providing electric heating by resistance heat, electrostatic grounding of charges, electromagnetic
screening and so on.

For all of these purposes and probably for many other purposes,
an electric conductivity is required, which is essentially higher
than the one which one could achieve exclusively by the method protected by the said patent. It is true that the electric conductivity obtained by the said method is sufficient in order that one shall
by a subsequent treatment amplify the layer or make same thicker,
respectivly, but in practical use such electrolytic treatment afterwards caused a lot of practical inconveniences.  First, it means an
inconvenience that one has to treat the material in two different processes after each other, because, thereby, the total of the treatment
will consume a longer time and get more expensive.  Second, it has
proved in practical tests that the layer obtained by the two consecutive
processes shows certain unevenesses causing that the material will get
electric properties difficult to calculate.

The present invention, thus, is based upon a serie of comprehensive tests in which one tried, maintaining the general idea of the known
method, not only to make possible that all of the metallization be executed at one single time, but also cause the metal layer produced to be
tighter.  The last mentioned, especially, is important because a tighter metallic layer will not only give a better electric conductivity
but also cause a more even cover.  The more even distribution of the
thickness of the cover, in turn, causes that calculations for determining the time of treatment, the concentration of the bath and the like
for obtaining a product, which is more stable and corresponds better to
the desires in the form of the textile material and the metallic layer
deposited thereon, will get both more simple and more reliable.

The said tests have proved that one may achieve all of the said
advantages if one   uses, instead of the simple chemical compositions
proposed in the earlier patent specification in the form of chlorides,
sulphates and so on, sulphamates, which means an essentially more complicated chemical compund.  As a matter of fact, the use of sulphamates, according to what has been proved in the tests forming basis
of the present invention, will create at the reduction an essentially
tighter cover of the metal depositied, which may for instance be one
from the iron group or some metal with a marked catalytic action.

Thus, the tests have given at hand that one may in empirical
way or by calculations forsee a composition of the bath, which will
at a high degree of accuracy give a layer with an electric conductivity, which can be chosen within a range of values, corresponding to
from 1 to 10'000 ohms/dm$^2$.  It has even proved possible to provide
layers of metal with an electric comductivity having values corresponding to until several megohms/dm$^2$ or down to fractions of 1 ohm/dm$^2$.

although the most reliable values are obtained within the range betwwen 1 and 10'000 ohms/dm$^2$.

When using the invention, one proceeds in the way more closely mentioned above, but, thereby, one has to use as a material in the deposit some salt of a metal of the iron group or of a metal which is marked catalytically active, and the bath of the salt has to be formed by a sulphamate of the said metal.

Thus, one provides a contact bond between the two mediums of different character, which means the textile material on the one side and the metal on the other side. Thereby, the textile material is first ionized, especially on its surface and preferably in such a way that each fibre, contained in the textile material is ionized around all of its circumference. The ionization may take place in many different ways, for instance by subjecting the material to an electric field or to radioactive radiation. One may also put the textile material in contact with a solution of a metallic salt by immersing or spraying, in the last mentioned case preferably with the sprayed material in the form of an aerosole. In any of the above ways, a metallic ion is fed fo the fibres or to such fibres which are contained in the textile material, respectively, which is of great importance for the adhession between the textile material and the metal deposit to be made.

The textile material, thus ionized, thereafter, is provided with the catalytically active metal, which may take place by immersing in a bath, or by spraying.

Preferably, for the ionization, titanium or tinn is used as metallic ion in a salt solution. The salt of titanium, thereby, for instance, may be titanium chloride, whereas the salt of tinn may be tinn fluoride or tinn fluor borate. It should be observed that the pre-treatement is mainly the same one which was mentioned in the above elder Swedish patent specification. Anyway, a pre-treatement may be used which is completely in accordance with the one earlier known.

Therefore, the new item of the invention is mainly represented by the subsequent metallization treatement.

After the pre-treatement thus mentioned, the textile material is namely ready for starting the final metallization treatement under catalysis and deposition of the metal, by which the fibres should be covered.

The bath in which the metallization takes place, therefore, should contain one or more of the metals of the iron group or one or more of some other metals having marked catalytic action. Amongst metals having the last mentioned action may be mentioned, in addition to the metals of the iron group, all of the metals of the platinum group, gold, cobalt, nickel and silver.

In the metal deposition earlier made according to the known method, one has used, as the metallic salt, the chloride or the sulphate of the metal concerned, but thereby one has observed the disadvantages mentioned above. The new principle of the invention, therefore, is that one uses for the metal deposition the sulphamate of the metal concerned.

The investigation forming basis of the present invention, further has proved that certain additions to the final metallization bath are either necessary or useful.

Thus, one ought to add a reduction means. As such reduction means, one may use most reduction means known per se but it has proved especially advantageous to use amino borane, hypo phosphates, hydrazone or formaline.

If it is desired to make sure a high tightness of the material deposited one may also add a means having a power of decreasing the magnitude of the crystals. By each of the crystals getting smaller, namely, in a way known per se the total of the crystals formed will obtain a higher tightness. As tightness promoting means may be mentioned dextrine and algonates of a lot of metals, amongst which, in first place, should be mentioned one or two value metals such as sodium, potash and calcium.

Finally, it may be advantageous to add to the bath complex forming means. They are, preferably, salts of mono value metals, id est sodium and potash, in the form of the citrates, tartrates or clycolates of said metals.

The pH of the bath has proved, in the tests, preferably to be between 3 and 13. The temperature, as a rule, is not very critical, but anyhow it should be above the ambient temperature but below the boiling temperature of the solution means, preferably so far below said temperature that there will be no appreciable evaporation. In the examples

- 5 -

mentioned below, thus, temperatures are used during the treatement in the bath of between 30° and 70° C.   This interval of temperatures may be regarded illustrative to suitable temperatures.

Therefore, below, a number of examples of metallization baths according to the present invetnion will be given, but it is understood that the invention shall not be regarded limited to these specific examples, but that all different kinds of modifications may exist within the scope of the invention.   Thus, one may use sulphonate of other metals than those, mentioned in the examples, and one may add other reduction means than the ones mentioned.   One may omit adding crystal size reduction means or complex forming means, and if such means are nevertheless added of one or the other one of said types, one may use other  such means than those mentioned in the examples.

Also, the quantity of the material used may be another than the one mentioned in the examples, and other pH-values and/or temperatures may be used.   As there are very wide possibilities of variation within the scope ot the invention dependent upon, for instance, the type of the textile material to be treated, the purpose of the treatement and the metal to be deposited on the textile material, the man skilled in the art will have either to operate on basis of professional experience achieved or empirically, in each separate case, to state the most favourable values.   Such an empirical statement, however will be within the usual knowledge of the man skilled in the art.

Example I:

| Sulphamate of nickel | 20 gr/lit | pH-value | 5,5 |
| Citrate of sodium | 30 gr/lit | working temperature | 70° C |
| Di metyle amino borane | 5 gr/lit | | |
| Dextrine | 0,1 gr/lit | | |

Example II:

| Sulpha mate of cobalt | 15 gr/lit | pH-value | 6,9 |
| Acetate of sodium | 25 gr/lit | working temperature | 60° C |
| Hypohosfite of sodium | 10 gr/lit | | |
| Alginate of sodium | 0,2 gr/lit | | |

Example III:

| Sulpha mate of copper | 10 gr/lit | pH-value | 9,5 |
| Tartrate of potasch-so-dium | 30 gr/lit | working temperature | 30° C |
| Sodium hydroxide | 3 gr/lit | | |
| Formaline (37%) | 9,5 gr/lit | | |

C l a i m s

1. A method for metallization of textile, preferably fibruous materials or materials comprising separate textile fibres, respectively, in which, after removal of impurities and perhaps existing appreture means, the material is ionized and is immersed into a bath comprising a salt of a catalytically active metal or metals, respectively, which should be deposited along with a reduction means, c h a r a c t e r i z e d thereby that the salt of the catalytically active metal or metals, resepctively, is a sulphamate or a mixture of two or more sulphamates.

2. A method according to claim 1, c h a r a c t e r i z e d thereby that titanium or tinn in the form of metallic ions in a salt solution is used for the ionization.

3. A method according to claim 2, c h a r a c t e r i z e·d thereby that the salt of titanium is titanium chloride and that the salt of tinn is tinn fluoride of tinn fluoro borate.

4. A method according to any of the above claims, c h a r a c t e r i z e d thereby that some· of the metals of the iron group or the platinum group or gold or silver or nickel, either alone or in combination, is used as the catalytically active metal.

5. A method according to any of the above claims, c h a r a c t e r i z e d thereby that amino borates, hypo phosphates, hydrazone and/or formaline is used as reduction means.

6. A method according to any of the above claims, c h a r a c t e r i z e d therby that a means is added to the catalytically active bath, said means promoting the tightness be decreasing the magnitude of the crystals.

7. A method according to claim 6, c h a r a c t e r i z e d thereby that the tightness promoting means is dextrine and/or algonates of a preferably one or two value metal such as sodium, potash or calcium.

8. A method according to any of the above claims, c h a - r a c t e r i z e d thereby that a complex forming means is added to the catalytically active metallization bath.

9. A method according to claim 8, c h a r a c t e r i z e d thereby that the complex forming means is a citrate, an acetate, a tartrate or a glycolate of a one-value metal, viz sodium or potash.

10. A method according to any of the above claims, c h a - r a c t e r i z e d thereby that the metallization procedure is carried through at a pH-value between 3 and 13.

11. A method according to any of the above claims, c h a - r a c t e r i z e d thereby that the metallization procedure is taking place at a temperature in the bath of between 30 and 70° C.